# EUROPEAN PATENT APPLICATION

(11) **EP 2 197 044 A1**
(43) Date of publication of application: **16.06.2010**
(21) Application number: 08832729.1
(22) Date of filing: 17.09.2008
(51) Int. Cl.: H01L 31/18, H01L 31/0224, C23C 14/08, C23C 14/35

(54) **SOLAR BATTERY MANUFACTURING METHOD**

(30) Priority: 19.09.2007 JP 2007242608
(71) Applicant: Ulvac, Inc., Chigasaki-shi Kanagawa 253-8543 (JP)
(72) Inventor: TAKAHASHI, Hirohisa, Sanmu-shi Chiba 289-1297 (JP); ISHIBASHI, Satoru, Sanmu-shi Chiba 289-1297 (JP); SUGIURA, Isao, Sanmu-shi Chiba 289-1297 (JP); TAKASAWA, Satoru, Sanmu-shi Chiba 289-1297 (JP)
(74) Representative: Eisenführ, Speiser & Partner
(86) International application number: PCT/JP2008/066771
(87) International publication number: WO 2009/038094

(57) **Abstract**

A method for manufacturing a solar cell provided with an upper electrode which functions as an electrode for extracting electric power at a light incidence side of the solar cell and includes a ZnO-based transparent conductive film, the method comprising: forming the upper electrode by sputtering a target on which a formation material of the transparent conductive film is provided while applying sputtering voltage of 340V or less and generating a horizontal magnetic field on a target surface.

## Description

### [Technical Field]

The present invention relates to a method for manufacturing a solar cell.
Priority is claimed on Japanese Patent Application No. 2007-242608, filed September 19, 2007, the contents of which are incorporated herein by reference.

### [Background Art]

ITO (In₂O₃-SnO₂), a transparent conductive material, has been used to form the electrodes of solar cells. A recent concern regarding ITO is a possible increase in price due to unavailability of indium (In), which is a rare metal used to synthesize ITO. As an alternative transparent conductive material to ITO, a ZnO-based material has been recognized for its availability and low price (see, for example, Patent Document 1). The ZnO-based material is suited for sputtering to deposit a uniform film on a large-sized substrate. A film may be deposited in a simple manner by substituting a target of the ZnO-based material for an In₂O₃-based material. The ZnO-based material does not include lower oxide (InO) having high insulating property which the In₂O₃-based material possesses.
[Patent Document 1] Japanese Unexamined Patent Application, First Publication No. H9-87833

### [Disclosure of Invention]

### [Problems to be Solved by the Invention]

The ZnO-based material is next to ITO in terms of low resistance. In general, the specific resistance of the ZnO-based material is 500 to 1000 µΩcm, which is 2.5 to 5 times that of ITO. Such high specific resistance of the ZnO-based material, when employed as an electrode material of a solar cell, may impair the electric power extraction efficiency of the solar cell. There is therefore a demand for ZnO-based materials with even lower resistance.

The invention is made in view of the aforementioned circumstances and an object thereof is to provide a method for manufacturing a solar cell that includes a transparent conductive film of a ZnO-based material with low specific resistance.

### [Means for Solving the Problems]

The present inventors found that specific resistance of a ZnO-based film is affected by sputtering voltage and magnetic field strength at the time of film deposition. It has been known that the specific resistance of a ZnO-based film depends greatly on film thickness and the degree of oxidization. However, since such film thickness or a degree of oxidization vary widely, the dependency of specific resistance on sputtering voltage or magnetic field strength has not been confirmed. A present invention for development of a method for forming a thick ZnO-based film as a transparent electrode for solar cells, has found dependency of specific resistance on sputtering voltage and magnetic field strength.

The invention employs the followings in order to solve the aforementioned problems and achieve the object.
(1) A method for manufacturing a solar cell provided with an upper electrode which functions as an electrode for extracting electric power at a light incidence side of the solar cell and includes a ZnO-based transparent conductive film, the method comprising: forming the upper electrode by sputtering a target on which a formation material of the transparent conductive film is provided while applying sputtering voltage of 340V or less and generating a horizontal magnetic field on a target surface.
(2) The formation material of the transparent conductive film provided on the target may preferably be ZnO to which an Al-containing material is doped.
(3) In the process of forming the upper electrode, the target may preferably be sputtered with the maximum horizontal magnetic field strength on the surface thereof being not less than 600 gauss.

According to the method for manufacturing a solar cell as recited in (1), a ZnO-based film with a well-defined crystalline lattice can be obtained, and thereby obtaining a transparent conductive film with low specific resistance. Since the transparent conductive film is formed on an upper electrode of the solar cell, the transparent conductive film transmits light so that incoming light reaches a cell formed adjacent to the upper electrode. Such a configuration also provides electrical conductivity where it can extract electrons generated by photovoltaic power.
In the case of (2), a ZnO material to which an Al-containing material is doped is used as the formation material of the transparent conductive film provided at the target. Thus, a transparent conductive film with especially low specific resistance among other ZnO-based films can be obtained.

(4) A magnetic field generating device for generating a horizontal magnetic field on the target surface may preferably include a first magnet with a first polarity and a second magnet with a second polarity disposed along a rear surface of the target; and the second magnet may preferably be disposed to surround the first magnet.
   In this case, a strong horizontal magnetic field can be generated on the target surface to facilitate formation of a ZnO-based film with a well-defined crystalline lattice. Thus, a transparent conductive film with a low specific resistance and a high heat resistance can be obtained.

(5) In the process of forming the upper electrode, it is preferable that the target is sputtered while relative positions of the magnetic field generating device for generating a horizontal magnetic field on the target surface and the target are changing.
   In this case, a non-eroded area can be reduced. In addition, efficiency in the use of the target can be increased and introduced power can be increased.

(6) In the process of forming the upper electrode, it is preferable that the target is sputtered while relative positions of a substrate on which the upper electrode is to be formed and the target are changing.
   In this case, a uniform transparent conductive film can be provided on the entire substrate.

(7) The sputtering voltage may preferably be applied from both a direct current power supply and a high-frequency power supply.
   In this case, sputtering voltage can be decreased. Thus, a ZnO-based film with a well-defined crystalline lattice can be deposited, thereby a transparent conductive film with low specific resistance can be obtained.

### [Effect of the Invention]

According to the present invention, a ZnO-based film with a well-defined crystalline lattice can be obtained. Therefore, it is possible to provide a solar cell having a transparent conductive film with low specific resistance.

### [Brief Description of the Drawings]

[FIG. 1] FIG. 1 schematically illustrates a configuration of a magnetron sputtering apparatus according to an embodiment of the invention.
[FIG. 2] FIG. 2 is a plan view of a film deposition chamber.
[FIG. 3] FIG. 3 is a front view of a sputtering cathode mechanism.
[FIG. 4] FIG. 4 illustrates a modified embodiment of the magnetron sputtering apparatus.
[FIG. 5] FIG. 5 schematically illustrates a configuration of a solar cell.
[FIG. 6] FIG 6 is a graph illustrating a relationship between horizontal magnetic field strength and sputtering voltage.
[FIG. 7] FIG. 7 is a graph illustrating a relationship between thickness of a ZnO-based film and specific resistance.
[FIG. 8] FIG. 8 is a graph illustrating a relationship between sputtering voltage and specific resistance.
[FIG. 9A] FIG. 9A is a graph illustrating a relationship between an annealing temperature and specific resistance when the annealing temperature is 350°C or less.
[FIG. 9B] FIG. 9B is a graph illustrating a relationship between an annealing temperature and specific resistance when the annealing temperature is not lower than 350°C.

### [Reference Numerals]

- 5:: substrate
- 10:: magnetron sputtering apparatus
- 22:: target
- 26:: DC power supply (voltage applying device)
- 30:: magnetic circuit (magnetic field generating device)
- 31:: first magnet
- 32:: second magnet
- 50:: solar cell
- 51:: glass substrate (substrate)
- 53:: upper electrode

### [Best Mode for Implementing the Invention]

Referring now to the drawings, a method for manufacturing a solar cell according to an embodiment of the present invention will be described.

### (Magnetron Sputtering Apparatus)

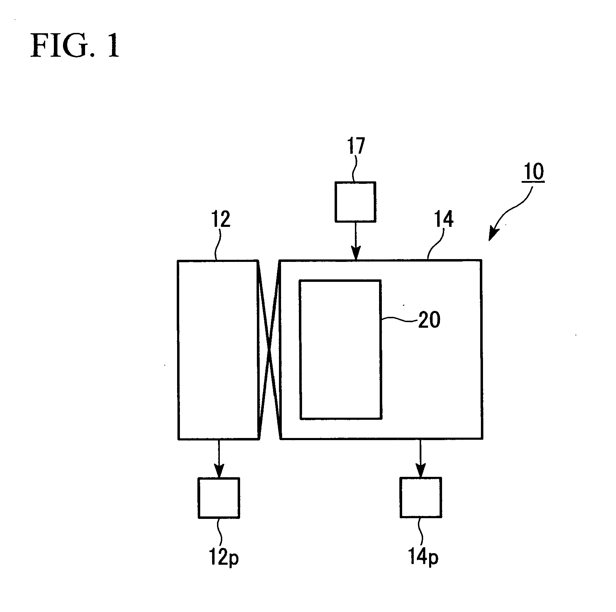

FIG. 1 schematically illustrates a configuration of a magnetron sputtering apparatus. A sputtering apparatus 10 according to the present embodiment is an interback-type sputtering apparatus, which includes a carry-in/out chamber 12 for a substrate (not shown in FIG. 1) and a film deposition chamber 14 in which a film is deposited on the substrate. A roughing exhauster 12p, such as a rotary pump, is connected to the carry-in/out chamber 12. A high-vacuum exhauster 14p, such as a turbo-molecular pump, is connected to the film deposition chamber 14. In the sputtering apparatus 10 according to the present embodiment, the substrate supported in a vertical position is carried into the carry-in/out chamber 12, and then the carry-in/out chamber 12 is evacuated by the roughing exhauster 12p. Next, the substrate is conveyed into the film deposition chamber 14 which is highly evacuated by a high-vacuum exhauster 14p, and then a film is deposited on the substrate. The substrate having a film deposited thereon is taken out via the carry-in/out chamber 12.

A gas supply unit 17 which supplies sputtering gas, such as Ar, is connected to the film deposition chamber 14. The gas supply unit 17 may also supply reactant gas, such as O₂. A sputtering cathode mechanism 20 is disposed vertically in the film deposition chamber 14.

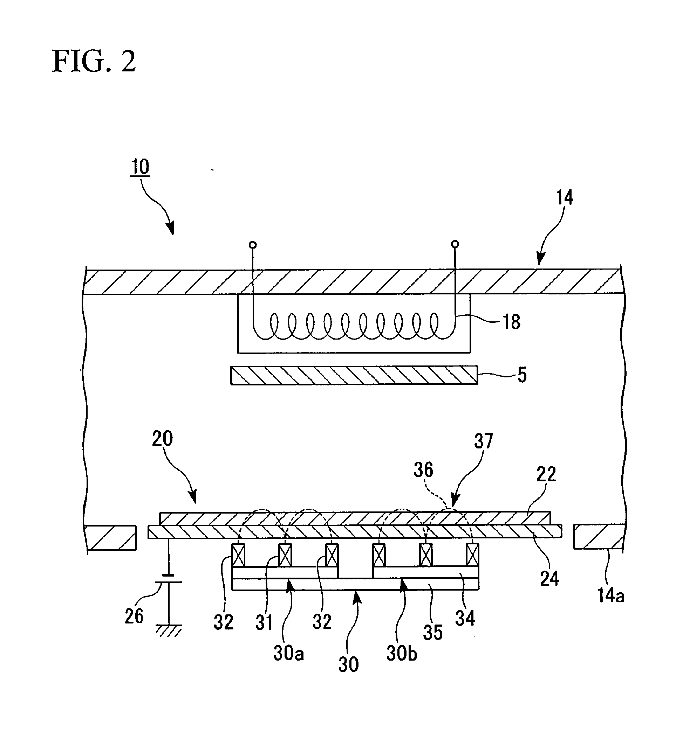

FIG. 2 is a plan view of the film deposition chamber 14. The sputtering cathode mechanism 20 is disposed at one width-direction end of the film deposition chamber 14. A heater 18 for heating the substrate 5 is disposed at another width-direction end of the film deposition chamber 14.

The sputtering cathode mechanism 20 mainly includes a target 22, a backing plate 24 and a magnetic circuit 30. The backing plate 24 is connected to a DC power supply 26 and held at negative potential. A target 22 brazed with a formation material of the ZnO-based film is disposed on a surface of the backing plate 24. The formation material of the ZnO-based film is ZnO to which an Al-containing material is doped.
Sputtering gas is supplied into the film deposition chamber 14 from the gas supply unit 17, and sputtering voltage is applied to the backing plate 24 by the DC power supply 26. Then, sputtering gas ions excited by plasma within the film deposition chamber 14 bombard the target 22 so that atoms of the formation material of the ZnO-based film are ejected. The ejected atoms adhere to the substrate 5 to provide a film of the ZnO-based material on the substrate 5.

A magnetic circuit 30 generating a horizontal magnetic field on a surface of the target 22 is placed along a back surface of the backing plate 24. The magnetic circuit 30 includes a first magnet 31 and a second magnet 32 which are polarized opposite to each other at their surfaces facing the backing plate 24.

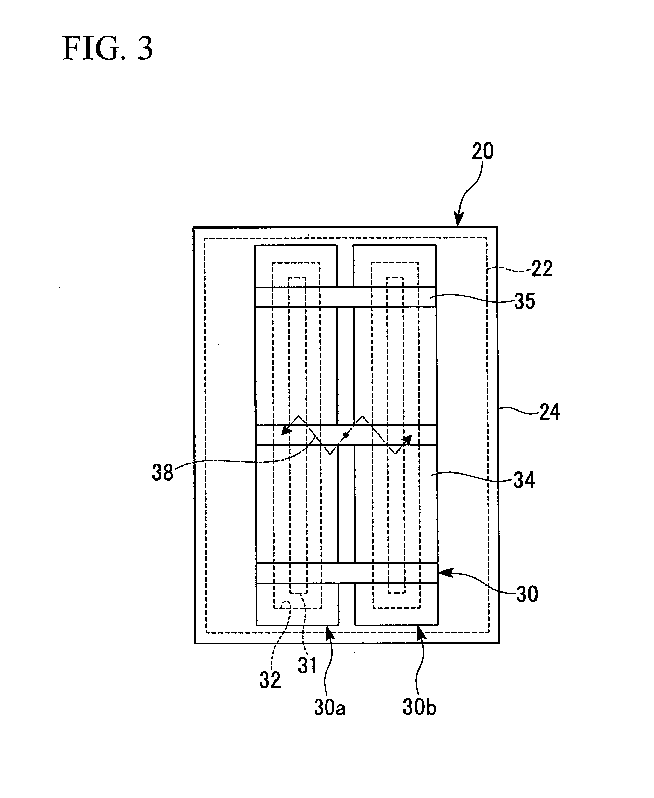

FIG. 3 is a rear elevation of the sputtering cathode mechanism 20. The first magnet 31 is disposed linearly. The second magnet 32 is disposed in a frame configuration surrounding the first magnet 31 with a predetermined distance from a periphery of the first magnet 31.
The first magnets 31 and the second magnets 32 are mounted on a yoke 34 to form a magnetic circuit unit 30a. Multiple (two in the present embodiment) magnetic circuit units 30a and 30b are connected to each other with a bracket 35 to form the magnetic circuit 30.

As illustrated in FIG. 2, a magnetic field represented by a magnetic field line 36 is generated by the first magnet 31 and the second magnet 32 which are polarized opposite to each other at the backing plate 24 side thereof. According to this configuration, positions 37 with a vertical magnetic field of 0 (and the maximum horizontal magnetic field) appear on the surface of the target 22 between the first magnet 31 and the second magnet 32. As high-density plasma is generated at the positions 37, the film deposition speed is accelerated.

The target 22 is eroded most deeply at the positions 37. The magnetic circuit 30 may fluctuate horizontally so that the positions 37 are not fixed in order to increase the efficiency in the use of the target (i.e., lifetime of the target) and that cooling efficiency of the target and the cathode is increased in order to improve arcing or other property. The eroded configuration is rectangular or semicircular at upper and lower ends of the target 22. Thus, the magnetic circuit 30 may also fluctuate vertically. In particular, a pair of horizontal and vertical actuators (not illustrated) are provided to make the bracket 35 of the magnetic circuit 30 reciprocate horizontally and vertically. When these horizontal and vertical actuators are driven at different cycles, the magnetic circuit 30 fluctuates in a zigzag manner within a surface parallel to the target 22.

### (Modified Embodiment)

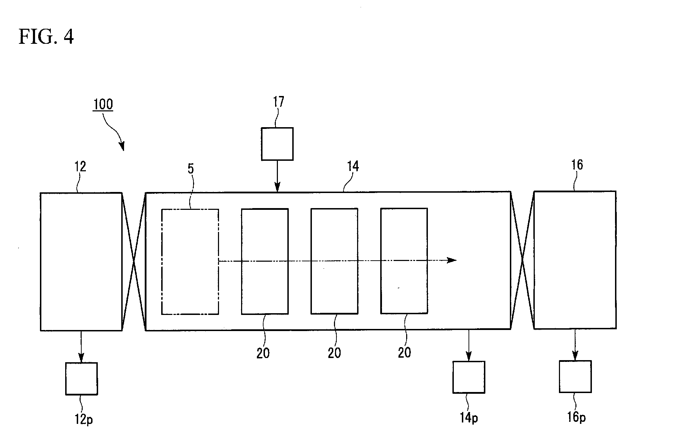

FIG. 4 illustrates a modified embodiment of the magnetron sputtering apparatus. A sputtering apparatus 100 according to the modified embodiment is an in-line type sputtering apparatus which includes a carry-in chamber 12, a film deposition chamber 14 and a carry-out chamber 16 in this order. In the sputtering apparatus 100, the substrate supported in a vertical position is carried into the carry-in chamber 12 and then the carry-in chamber 12 is evacuated by a roughing exhauster 12p. Next, the substrate 5 is conveyed into the film deposition chamber 14 which is highly evacuated by a high-vacuum exhauster 14p where a film is deposited on the substrate 5. The substrate 5 having a film deposited thereon is taken out via the carry-out chamber 16 which is evacuated by a roughing exhauster 16p.

Multiple (three in the modified embodiment) sputtering cathode mechanisms 20 are disposed in a conveyance direction of the substrate 5 within the film deposition chamber 14. Each sputtering cathode mechanism 20 is configured in the same manner as that of the embodiment described above. In the modified embodiment, a ZnO-based film is formed on a surface of the substrate 5 with the each sputtering cathode mechanisms 20 as the substrate 5 passes in front of the sputtering cathode mechanisms 20.
In this manner, a uniform ZnO-based film can be deposited with increased throughput of the film deposition process.

### (Solar cell)

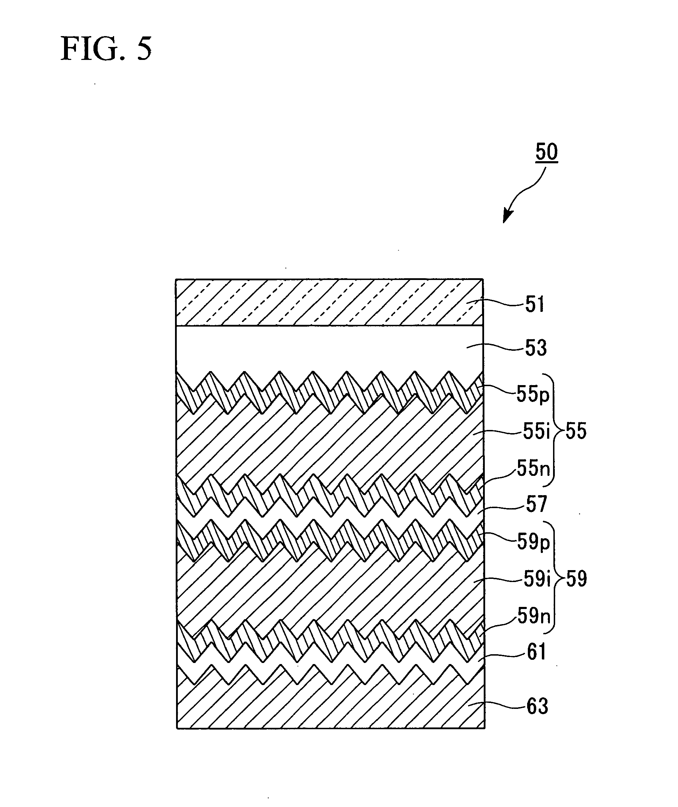

Referring now to FIG. 5, a solar cell manufactured in the method according to the present embodiment will be described. FIG. 5 schematically illustrates a configuration of the solar cell.
As illustrated in FIG. 5, the solar cell 50 includes: a glass substrate 51 constituting a surface of the solar cell 50; an upper electrode 53 comprising a transparent conductive film and provided on the glass substrate 51; a top cell 55 formed of amorphous silicon; an intermediate electrode 57 being a transparent conductive film and disposed between the top cell 55 and the bottom cell 59, which will be described later; a bottom cell 59 formed of microcrystal silicon; a buffer layer 61 being a transparent conductive film; and a rear electrode 63 being a metal film; which are laminated together. Thus, the solar cell 50 is an a-Si/micro crystallite Si tandem solar cell. In such a tandem solar cell 50, short wavelength light is absorbed by the top cell 55 and long wavelength light is absorbed by the bottom cell 59. With this configuration, power generation efficiency can be increased. The film thickness of the upper electrode 53 is 2000 to 10000 angstrom.

The top cell 55 has a three layer structure consisting of a p-layer (55p), an i-layer (55i) and an n-layer (55n). The i-layer (55i) is formed of amorphous silicon. The bottom cell 59 also has a three-layer structure consisting of a p-layer (59p), an i-layer (59i) and an n-layer (59n) like the top cell 55. The i-layer (59i) is formed of microcrystal silicon.

In the thus-structured solar cell 50, when energy particles called photons included in sunlight bombard the i-layer, electrons and electron holes (i.e., holes) are generated by a photovoltaic effect. The electrons move toward the n-layer and the electron holes move toward the p-layer. The electrons generated by the photovoltaic effect are extracted from the upper electrode 53 and the rear electrode 63. In this manner, light energy is converted to electrical energy.

Since the intermediate electrode 57 is disposed between the top cell 55 and the bottom cell 59, partial light passing through the top cell 55 and reaching the bottom cell 59 is reflected by the intermediate electrode 57 and incident into the top cell 55 again. Thus, the sensitivity characteristic of the cell is improved and power generation efficiency is increased.

Sunlight incident from the glass substrate 51 side passes through the layers and is reflected by the rear electrode 63. In order to increase conversion efficiency of the light energy, the solar cell 50 employs a texture structure which provides a prism effect for extending an optical path of sunlight incident into the upper electrode 53 and a light trapping effect.

The upper electrode 53 of the solar cell 50 according to the present embodiment is configured by a ZnO-based film (i.e., a transparent conductive film) formed with the magnetron sputtering apparatus 10 described above. It is necessary for the upper electrode 53 to transmit light that is absorbed by the i-layer and to possess electrical conductivity for extracting electrons generated by the photovoltaic power. Accordingly, the upper electrode 53 should have low specific resistance. To obtain the upper electrode 53 with low specific resistance, an Al₂O₃-doped ZnO target is sputtered to form an Al-doped ZnO (AZO) film. Thus, a transparent conductive film with especially low specific resistance among other ZnO-based films can be obtained.

### (Method for Manufacturing Solar cell)

In the present embodiment, the Al-doped ZnO (AZO) film is formed on a glass substrate 51 as the upper electrode 53 using the sputtering apparatus 10 illustrated in FIGS. 1 to 3. Conductivity of the ZnO-based film is established when oxygen holes are formed in crystals and free electrons are emitted therefrom. Since the ZnO-based film oxidizes quite easily, it is desired to deposit a film with heat in order to reduce influences of an oxidizing source through degassing. The ZnO-based film has characteristics such that conductivity of the ZnO-based film increases when Al or other substances enter Zn sites in the crystals, form ions and emit free electrons. From this viewpoint, film deposition with heat that easily causes migration is advantageously employed.

In the target 22 illustrated in FIG. 2, ZnO to which Al₂O₃ is doped in an amount of 0.5 to 10.0 wt% (2.0 wt% in the present embodiment) is employed as a formation material of the transparent conductive film. A non-alkali glass substrate 51 is carried into the film deposition chamber 14 and heated to 100 to 600°C (200°C in the present embodiment) by the heater 18. The film deposition chamber 14 is highly evacuated by the high-vacuum exhauster 14p. Ar gas is introduced into the film deposition chamber 14 as a sputtering gas from the gas supply unit 17. Pressure in the film deposition chamber 14 is kept at 2 to 10 mTorr (5 mTorr in the present embodiment). Electric power having power density of 1 to 8 W/cm² (4 W/cm² in the present embodiment) is introduced to the backing plate 24 from the DC power supply 26 while the magnetic circuit 30 is fluctuating. Although the thus-deposited film is not annealed because the film is deposited with heat, the deposited film may be annealed alternatively.

As described above, the conductivity of the ZnO-based film increases when Al or other substances enter Zn sites in the crystals, form ions and emit free electrons. An Al₂O₃-doped ZnO target is sputtered to form an Al- doped ZnO (AZO) film to obtain a transparent conductive film with low specific resistance. In this manner, a transparent conductive film with especially low specific resistance among other ZnO-based films can be obtained.

The present inventors evaluated dependency of specific resistance of the ZnO-based film to magnetic field strength. For the evaluation, the ZnO-based film was formed at two levels: a first level in which the magnetic circuit 30 was controlled to have a 300-gauss horizontal magnetic field strength on the target surface; and a second level in which the magnetic circuit 30 was controlled to have 1500-gauss horizontal magnetic field strength on the target surface. Specific resistance of the obtained ZnO-based films of each level having a thickness of 2000, 5000, 10000 and 15000 angstroms was measured.

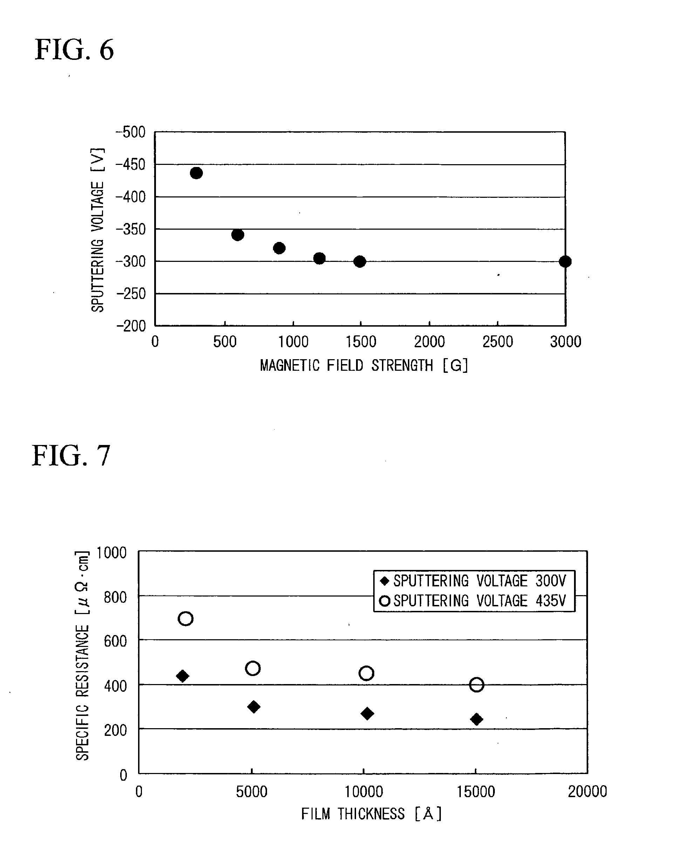

FIG. 6 is a graph illustrating a relationship between horizontal magnetic field strength and sputtering voltage. As horizontal magnetic field strength increases, the sputtering voltage decreases as illustrated in FIG 6. Generally, sputtering voltage is affected by discharge impedance (i.e., target voltage/target current) and the discharge impedance is affected by magnetic field strength on the target surface. As magnetic field strength becomes large, plasma density also becomes large and, as a result, sputtering voltage decreases. Sputtering voltage of the first level (horizontal magnetic field strength: 300 gauss) is about 450V and sputtering voltage of the second level (horizontal magnetic field strength: 1500 gauss) is about 300V.

FIG. 7 is a graph illustrating a relationship between the thickness of the ZnO-based film and specific resistance. Since specific resistance of the ZnO-based material depends on the film thickness, the specific resistance decreases as the thickness increases.
The specific resistance of the ZnO-based film formed at the second level (1500 gauss, 300V) is smaller than that of the first level (300 gauss, 435V). The reason for this phenomenon is considered as follows. Since the specific resistance depends on the film thickness, the crystalline lattice of the ZnO-based material is difficult to define. A ZnO-based film formed at a high sputtering voltage (i.e., a weak magnetic field) has a high specific resistance because its crystalline lattice is not well defined. In this case, when the film thickness of the ZnO-based film is increased, the crystalline lattice becomes well-defined, thereby the specific resistance of such a ZnO-based film tends to decrease. However, since the crystalline lattice is poorly defined, such a ZnO-based film has larger specific resistance compared with that of a thin ZnO-based film formed at a low sputtering voltage (i.e., a strong magnetic field).

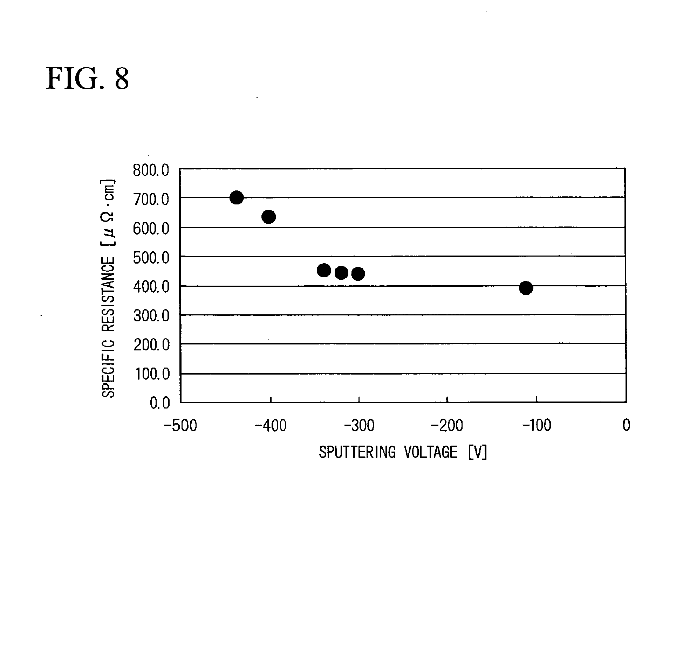

FIG. 8 is a graph illustrating a relationship between sputtering voltage (the sputtering voltages are described as negative potential) and specific resistance when a substrate is heated to 200°C and a 2000 angstrom-thick ZnO-based film is formed. The graph shows: the specific resistance is about 400 µΩcm in an absolute value range of the sputtering voltage of 340 or less; and the specific resistance increases rapidly in an absolute value range of the sputtering voltage of greater than 340V.

It is therefore desirable to form the ZnO-based film by sputtering with the sputtering voltage of 340V or less and with the maximum horizontal magnetic field strength on the target surface of not less than 600 gauss (see FIG. 6). Under these conditions, a ZnO-based film with a well-defined crystalline lattice can be provided and a ZnO-based film with low specific resistance (i.e., a thin film having specific resistance of 500 µΩcm or less) can be obtained. With such a low sputtering voltage of 340V or less, plasma-excited negative ions accelerated and bombard to the substrate are inhibited, and thus damage to a ground film or other films can be avoided.

The present inventors also evaluated dependency of heat resistance of the ZnO-based film on magnetic field strength. In particular, a 5000 angstrom-thick ZnO-based films were formed both at the first and second levels and annealed at varying temperatures. Then specific resistance of the thus-obtained ZnO-based films was measured. The deposited film was annealed at varying temperatures of 150 to 600°C (every 50°C) in the atmosphere for one hour.

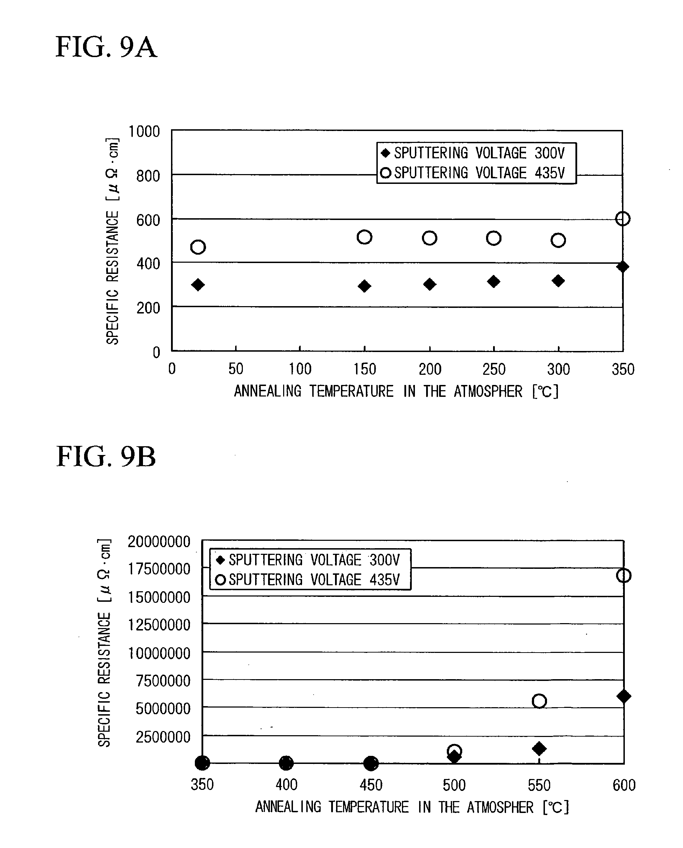

FIGS. 9A and 9B are graphs illustrating a relationship between the annealing temperature and specific resistance. FIG. 9A is a graph showing a relationship between an annealing temperature and specific resistance when the annealing temperature is 350°C or less. FIG 9B is a graph showing a relationship between an annealing temperature and specific resistance when the annealing temperature is not lower than 350°C. When the annealing temperature was 450°C or less, the specific resistance does not increase rapidly at both the first and second levels. On the contrary, when the annealing temperature is not lower than 500°C as illustrated in FIG. 9B, the specific resistance of the ZnO-based film at the second level (1500 gauss, 300V) is smaller than that of the first level (300 gauss, 435V).

The reason of this phenomenon is considered to be as follows. Conductivity of the ZnO-based film is established when oxygen holes are formed in crystals and free electrons are emitted therefrom. As described above, although the crystalline lattice of the ZnO-based film formed at high sputtering voltage (i.e., a weak magnetic field) is not well-defined, a more poorly-defined crystalline lattice tends to bond with oxygen more easily. Accordingly, the ZnO-based film formed at high sputtering voltage (i.e., a weak magnetic field) oxidizes easily when annealed at high temperature after being deposited and thus has higher specific resistance compared with that of the ZnO-based film formed at low sputtering voltage (i.e., a strong magnetic field).

As described above, it is therefore desirable to form the ZnO-based film by the sputtering with the sputtering voltage of 340V or less (or less than 340V) and with a maximum horizontal magnetic field strength on the target surface of not less than 600 gauss. Since the thus-obtained ZnO-based film has a well-defined crystalline lattice, the ZnO-based film is hard to oxidize even when annealed at high temperature after the film deposition. As a result, an increase in specific resistance can be suppressed. That is, a ZnO-based film with excellent heat resistance can be obtained.
Accordingly, when the substrate is taken out into ambient air after a film is formed thereon by heating deposition, a cooling process of the substrate may be eliminated or simplified, which may reduce the manufacturing costs.

After the upper electrode 53 is formed on the glass substrate 51 as described above, the top cell 55 is formed on the upper electrode 53. After the top cell 55 is formed, an Al-doped ZnO (AZO) film is formed on the top cell 55 as the intermediate electrode 57 in the same manner as that of the upper electrode 53. When forming the intermediate electrode 57, a ZnO (GZO) film to which Ga, not Al, is doped may be formed.

After forming the intermediate electrode 57, the bottom cell 59 is formed thereon. After the bottom cell 59 is formed, an Al-doped ZnO (AZO) film is formed on the bottom cell 59 as a buffer layer 61 in the same manner as those of the upper electrode 53 and the intermediate electrode 57. When forming the buffer layer 61, a ZnO (GZO) film to which Ga, not Al, is doped may be formed.
Then, after the buffer layer 61 is formed, the rear electrode 63 comprising a metal film, such as an Ag film or an Al film, is formed thereon to complete the solar cell 50. In consideration of the heat resistance of the power generation-layer (i.e., the top cell 55 or the bottom cell 59), the intermediate electrode 57 and the buffer layer 61 may preferably be formed at a temperature of 200°C or less.

The present embodiment is directed to a method for manufacturing the solar cell 50 provided with the upper electrode 53 which functions as an electrode for extracting electric power at a light incidence side of the solar cell and is configured by the ZnO-based transparent conductive film. This method includes a process of forming the upper electrode 53 by sputtering the target 22 on which a formation material of the transparent conductive film is provided while applying sputtering voltage and generating a horizontal magnetic field on the surface of the target 22. In the process of forming the upper electrode 53, the target is sputtered at the sputtering voltage of 340V or less.
The formation material of the transparent conductive film provided on the target 22 is ZnO to which an Al-containing material is doped.
The target 22 is sputtered with the maximum horizontal magnetic field strength of not less than 600 gauss on the surface thereof.

This configuration provides a ZnO-based film with a well-defined crystalline lattice, thereby a transparent conductive film with low specific resistance can be obtained. Since the obtained ZnO-based film has a well-defined crystalline lattice, the ZnO-based film is hard to oxidize even when heated at high temperature. Thus, a transparent conductive film with excellent heat resistance can be obtained. Moreover, forming the transparent conductive film on the upper electrode 53 of the solar cell 50, light can be made to be transmitted to the top cell 55 formed adjacent to the upper electrode 53. Such a configuration also provides electrical conductivity for extracting electrons generated by photovoltaic power.
Furthermore, the thickness of the upper electrode 53 can be reduced because the specific resistance of the transparent conductive film can be lowered, which reduces the manufacturing costs. Since the thickness of the upper electrode 53 can be reduced, light transmittance of the upper electrode 53 can also be increased.

It should be noted that the technical scope of the invention is not limited to the foregoing embodiments and various modifications may be made to the embodiments without departing from the spirit and scope of the invention.
Materials and configurations described above are for illustrative purposes only and may be changed suitably.
For example, although the sputtering apparatus according to the embodiment supports a substrate in a vertical position for the sputtering, the invention may be implemented with a sputtering apparatus which supports the substrate in a horizontal position.
Although the magnetic circuit unit according to the embodiment has the second magnet with second polarity disposed to surround the first magnet with a first polarity, a third magnet with first polarity may additionally be disposed to surround the second magnet to provide a magnetic circuit unit.
Although the present embodiment is directed to a tandem solar cell, the invention may similarly be applied to a single-junction solar cell. A single-junction solar cell refers to a solar cell similar to that illustrated in FIG. 5 but with no intermediate electrode or a bottom cell.

Although the DC power supply is employed in the sputtering cathode mechanism according to the embodiment, the DC power supply and a RF power may also be employed at the same time. When only the DC power supply is employed, specific resistance of the ZnO-based film (2000-angstrom thick) deposited at the sputtering voltage 300V is 436.6 µ Ω cm as illustrated in FIG. 8. On the contrary, in the case where a low current (4A) DC power supply and a 350W RF power are employed together, for example, the specific resistance of the ZnO-based film (2000-angstrom thick) formed at the sputtering voltage of about 100V with respect to a ZnO-2wt% Al₂O₃ target is 389.4 µΩcm. As described above, when the RF power is used together with the DC power supply, the sputtering voltage decreases. According to the decrease of the sputtering voltage, the specific resistance of the ZnO-based film also decreases. That is, the specific resistance of the ZnO-based film can be lowered with decreased sputtering voltage of the power supply in addition to reduced magnetic field strength.

### [Industrial Applicability]

According to the invention, it is possible to obtain a ZnO-based film with a well-defined crystalline lattice, thereby a transparent conductive film with low specific resistance can be provided. As the transparent conductive film is formed on an upper electrode of the solar cell, light can be made to be transmitted to the cell formed adjacent to the upper electrode, and electrical conductivity for extracting electrons generated through photovoltaic power can be ensured.

## Claims

1. A method for manufacturing a solar cell provided with an upper electrode which functions as an electrode for extracting electric power at a light incidence side of the solar cell and includes a ZnO-based transparent conductive film, the method comprising:
forming the upper electrode by sputtering a target on which a formation material of the transparent conductive film is provided while applying sputtering voltage of 340V or less and generating a horizontal magnetic field on a target surface.

2. The method for manufacturing a solar cell according to claim 1, wherein:
the formation material of the transparent conductive film provided on the target is ZnO to which an Al-containing material is doped.

3. The method for manufacturing a solar cell according to claim 1, wherein:
in the process of forming the upper electrode, the target is sputtered with the maximum horizontal magnetic field strength on the surface thereof being not less than 600 gauss.

4. The method for manufacturing a solar cell according to claim 1, wherein:
a magnetic field generating device for generating a horizontal magnetic field on the target surface includes a first magnet with a first polarity and a second magnet with a second polarity disposed along a rear surface of the target; and
the second magnet is disposed to surround the first magnet.

5. The method for manufacturing a solar cell according to claim 1, wherein:
in the process of forming the upper electrode, the target is sputtered while relative positions of the magnetic field generating device for generating a horizontal magnetic field on the target surface and the target are changing.

6. The method for manufacturing a solar cell according to claim 1, wherein:
in the process of forming the upper electrode, the target is sputtered while relative positions of a substrate on which the upper electrode is to be formed and the target are changing.

7. The method for manufacturing a solar cell according to claim 1, wherein:
the sputtering voltage is applied from both a direct current power supply and a high-frequency power supply.
